# EUROPÄISCHE PATENTANMELDUNG

(11) **EP 2 197 255 A1**
(43) Veröffentlichungstag der Anmeldung: **16.06.2010**
(21) Anmeldenummer: 08171661.5
(22) Anmeldetag: 15.12.2008
(51) Int. Cl.: H05K 7/20

(54) **Hermetisch geschlossenes Gehäusesystem, insbesondere Elektronikgehäuse, mit Schwingmembranlüfter**

(71) Anmelder: Siemens Aktiengesellschaft, 80333 München (DE)
(72) Erfinder: Busch, Klaus, 92224, Amberg (DE); Scharf, Christian, 92263, Ebermannsdorf (DE); Wiesner, Christoph, 92224, Amberg (DE)

(57) **Zusammenfassung**

Die Erfindung betrifft ein Gehäusesystem mit einem Hauptgehäuse (1) zur Aufnahme von Verlustwärme abgebenden elektrischen und/oder elektronischen Bauelementen (2, 21), insbesondere Leiterplatten, und zumindest einem Schwingmembranlüfter (3) in einem Teilgehäuse (31), wobei die Innenräume von Haupt- (1) und Teilgehäuse (31) ein geschlossenes Luftvolumen bilden.

## Beschreibung

Die Erfindung betrifft ein Gehäusesystem.

Die Entwärmung von Gehäusen, welche Verlustwärme abgebende elektrische und/oder elektronische Bauelemente enthalten, erfolgt in der Regel dadurch, dass ein gezielter Luftaustausch zwischen dem Inneren des Gehäuses und der Umgebung herbeigeführt wird. Hierzu weisen die Gehäuse eine unter Umständen große Anzahl von Lüftungsöffnungen auf. Über diese kann der Luftaustausch entweder mittels natürlicher Konvektion oder zwangsgeführt mit Hilfe von Gehäuselüftern bewirkt werden.

Eine derartig offene Gehäusebauweise weist aber eine Vielzahl von Problemen auf. So werden Schmutz und Staubpartikel über die Lüftungsöffnungen in das Innere des Gehäuses gefördert und lagern sich dort ab. Weiterhin sind Lüftungsöffnungen besonders dann problematisch, wenn das Gehäuse höheren Schutzanforderungen genügen soll, also z.B. der Schutzart IP 54, also spritzwasser- und staubdicht sein soll. Auch gegenüber einer elektromagnetischen Abschirmung, d.h. der Verhinderung des Ein- bzw. Austretens von elektromagnetischer Strahlung, stellen Lüftungsöffnungen häufig Leckstellen dar.

Besonders bei Gehäusen, welche in der industriellen Elektronik eingesetzt werden, besteht somit häufig die Notwendigkeit diese vollständig gegenüber äußeren Einwirkungen gekapselt auszuführen. Derartig gekapselte Gehäuse weisen aber in der Regel Probleme bei der Gehäuseentwärmung auf. Bei weniger kritischen Anwendungen mag es ausreichend sein, dass die von Bauelementen im Inneren auftretende Verlustwärme auf einfache Weise über die Gehäusewände nach außen abgeleitet wird. Sind allerdings im Inneren des Gehäuses starke Verlustwärmequellen vorhanden, z.B. hoch getaktete Prozessoren, so müssen in der Regel aufwändige Maßnahmen ergriffen werden, um die Verlustwärme von derartigen "Hot Spots" bis auf die Außenseite des gekapselten Gehäuses abzuleiten. Als ein Beispiel hierfür sollen Kombinationen von "Heat Pipes" und integrierten Lüftern genannt werden. Eine derartige Ausführung ist allerdings aufwändig und störanfällig. Besonders im Falle einer notwendigen Reparatur hatte dies zur Folge, dass das gekapselt die Gehäuse aufgebrochen werden muss und dabei häufig Dichtmittel beschädigt werden.

Es sind Lüfter bekannt, deren bewegliche Teile reibungsfrei und ohne Berührung zueinander gelagert sind. Deren Aufbau ist in gewisser Weise mit einem Lautsprecher vergleichbar. Lüfter dieser Art sind im englischen Sprachraum unter dem Begriff "Jet Cooler" beziehungsweise "Jet Generator" bekannt geworden und werden nachfolgend als Schwingmembranlüfter bezeichnet. Diese weisen eine in einem Gehäuse gehaltene Schwingmembran auf, welche von einem in einer Aktuatorkammer befindlichen Magnetsystem berührungslosen angeregt wird. Die von der Schwingmembran erzeugten Luftpulsierungen werden nach außen abgegeben. Hiermit kann zum Beispiel die von Elektronikbauelementen oder Prozessoren erzeugte Verlustwärme verwirbelt und von der Wärmequelle abgeführt werden.

Der Erfindung liegt somit die Aufgabe zu Grunde, ein gekapseltes Gehäuse der oben angegebenen Art weiter so auszubilden, dass eine wirkungsvolle und dauerhafte Entwärmung auch im Falle eines hermetischen Schlusses des Gehäuses gewährleistet ist.

Die Aufgabe wird gelöst mit dem im Anspruch 1 angegebenen Gehäusesystem. Vorteilhafte weitere Ausführungen der Erfindung sind in den Unteransprüchen angegeben.

Das erfindungsgemäße Gehäusesystem zeichnet sich dadurch aus, dass ein Hauptgehäuse, welches zur Aufnahme von Verlustwärme abgebenden elektrischen und/oder elektronischen Bauelementen, insbesondere von Leiterplatten, dient, und zumindest ein Schwingmembranlüfter in einem Teilgehäuse vorhanden sind, wobei die Innenräume von Haupt- und Teilgehäuse ein geschlossenes Luftvolumen bilden. Der hermetisch dichte Verschluss des Hauptgehäuses und damit die Anforderungen an mögliche Schutzvorschriften werden somit durch den Einsatz eines Schwingmembranlüfters in keiner Weise beeinträchtigt.

Bei dem mit mindestens einem Schwingmembranlüfter ausgestatteten Hauptgehäuse kann somit die Luft im Innenraum auf einfache Weise verwirbelt und somit von lokalen Wärmequellen, zum Beispiel Prozessoren, abgeleitet werden. Aufgrund dieser Vergleichmäßigung der Wärme im Inneren wird deren Ableitung über die Wände des Hauptgehäuses erheblich begünstigt, ohne dass hierzu um ein Luftaustausch mit der Umgebung notwendig ist. Zu dem eignen sich Schwingmembranlüfter besonders zum gezielten Aufbau von Luftpulsierungen und Luftströmungen im Inneren des Hauptgehäuses. Diese können vorteilhaft durch zusätzliche, an das Teilgehäuse des Schwingmembranlüfters angeschlossene Luftführungskanäle, hervorgerufen werden. Solche Luftführungskanäle können im Inneren des Hauptgehäuses so verlegt werden, dass besonders starke Wärmequellen einer von einer gezielten Luftströmung umspült werden.

Je nach Ausführung kann das mindestens eine Teilgehäuse mit dem Schwingmembranlüfter vollständig im Inneren des Hauptgehäuses angeordnet sein. Diese erste "integrierte Anordnung" des erfindungsgemäßen Gehäusesystems bietet den Vorteil, dass sowohl der Schwingmembranlüfter als auch daran angeschlossene Lüftungskanäle in einer an die jeweils vorliegenden Entwärmungsanforderungen optimal angepassten Weise im Inneren des Hauptgehäuses platziert und verlegt werden können.

Andererseits kann das Teilgehäuse des Schwingmembranlüfters auch außerhalb des Hauptgehäuses angeordnet und dessen Innenraum an den Innenraum des Hauptgehäuses über zumindest eine Durchführungsöffnung im Hauptgehäuse hermetisch dicht ankoppelt sein. Diese zweite "Huckepackanordnung" des erfindungsgemäßen Gehäusesystems bietet den besonderen Vorteil, dass das Hauptgehäuse nur bei Bedarf durch einen aufgesetzten Schwingmembranlüfter ergänzt zu werden braucht, ohne dass hierzu das Hauptgehäuse geöffnet und dabei mögliche Dichtungen beschädigt werden. In diesem Fall ist es vorteilhaft, wenn die mindestens eine Durchführungsöffnung in der Wandung des Hauptgehäuses wieder verschließbar ist, z.B. mittels Stopfen oder ähnlichen Verschlussmitteln. Besonders vorteilhaft kann in diesem Fall das Teilgehäuse des Schwingmembranlüfters direkt auf die Außenseite des Hauptgehäuses aufgesetzt und dessen Innenraum über mindestens eine Injektordüse unmittelbar an die zumindest eine Durchführungsöffnung dicht ankoppelt sein.

Die Erfindung betrifft also eine Gehäuseeinheit bzw. ein Gehäusesystem aus einem Hauptgehäuse, welches zur Aufnahme von Verlustwärme abgebenden Bauelementen dient, und zumindest einem damit hermetisch verbundenen Teilgehäuse eines Schwingmembranlüfters.

Die Erfindung wird nachfolgend an Hand von zwei, in den Figuren dargestellten Ausführungsbeispielen näher erläutert. Dabei zeigt
- Fig. 1: eine beispielhafte Ausführung für einen Schwingmembranlüfter, dessen Teilgehäuse unmittelbar auf ein Hauptgehäuse aufgesetzt ist, und wobei die Innenräume der Gehäuse über Injektordüsen lufttechnisch gekoppelt sind, und
- Fig. 2: eine zweite Ausführung, bei der das Teilgehäuse des Schwingmembranlüfters vollständig in ein Hauptgehäuse integriert ist.

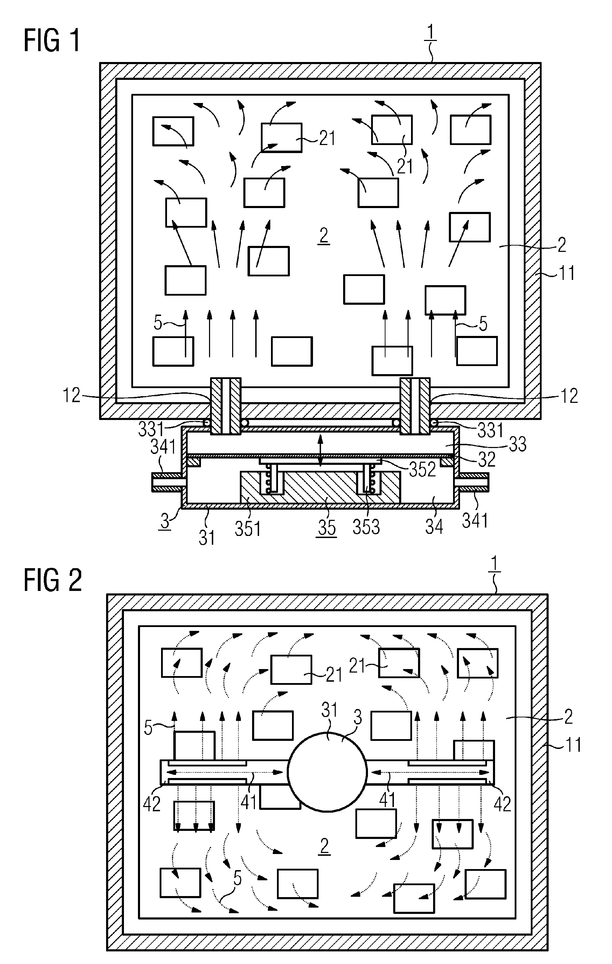

Das in Beispiel der in Figuren 1 und 2 dargestellte Hauptgehäuse 1 hat die Funktion eines Elektronikgehäuses, in dem eine elektronische Leiterplatte 2 als ein beispielhaftes, thermische Verlustenergie abgebendes Einbauteil gehalten ist. Diese ist mit einer Vielzahl von elektrischen Bauelementen 21 bestückt, z.B. mit SMD Bauteilen und so genannten "Hot Spot" Bauelementen, z.B. Prozessoren. Die Seitenflächen 11 des Hauptgehäuses 1 umschließen die innen liegenden Bauelemente hermetisch so dicht, dass erhöhte Anforderungen an Wasserdichtigkeit und Staubschutz z.B. gemäß der Schutzart IP 54 oder höher erfüllt werden.

Zur Förderung der Entwärmung der Bauelemente im Inneren des Hauptgehäuses 1 ist dieses erfindungsgemäß durch ein außerhalb angeordnetes Teilgehäuse 31 mit einem beispielhaften Schwingmembranlüfter 3 zu einem erfindungsgemäßen Gehäusesystems erweitert. Dabei wird beispielhaft das Teilgehäuse 31 des Schwingmembranlüfters 3 von einer Schwingmembran 32 in eine Düsen- und eine Aktuatorkammer 33, 34 geteilt. Die Schwingmembran 32 wird von einem, in der Aktuatorkammer 34 angeordneten Magnetsystem 35 zu Schwingungen angeregt, und die davon erzeugten Luftpulsierungen 5 zumindest über die Düsenkammer 33 abgegeben. Das im Beispiel der Figur dargestellte Magnetsystem 35 weist eine Magnetscheibe 351 mit einer Ringnut auf, in welche ein ringförmiger Spulenträger 352 berührungslos eintaucht. Dieser ist mit einer beispielhaft zylindrischen Spulenwicklung 353 belegt, welche von einer Wechselspannung mit z.B. einstellbarer Frequenz angeregt wird. Die Schwingmembran 32 ist auf einer, der jeweiligen Aktuatorkammer 34 zugewanderten Seite mit dem Spulenträger 352 des Magnetsystems 35 in der Art verbunden, dass dieser ohne Berührung in die jeweilige Ringnut eintauchen kann. Zur Erzeugung von Luftpulsierungen 5 wird die Spulenwicklung 353 mit einer Wechselspannung erregt, so dass der Spulenträger 352 ohne Reibung in der jeweiligen Ringnut in Schwingungen kommen kann.

Erfindungsgemäß bilden die Innenräume des Hauptgehäuses 1 und des Teilgehäuses 31 des Schwingmembranlüfters 3 ein geschlossenes Luftvolumen.

Bei der vorteilhaften Ausführungsform in Figuren 1 ist hierzu das Teilgehäuse 31 des Schwingmembranlüfters 3 auf die unten liegende Außenseite 11 des Hauptgehäuses 1 direkt aufgesetzt. Weiterhin ist zumindest der Innenraum der Düsenkammer 33 des Schwingmembranlüfters 3 über zwei Injektordüsen 331 hermetisch dicht an die ebenfalls zwei Durchführungsöffnungen 12 ankoppelt. Auf diese Weise werden die von der Schwingmembran 32 erzeugten Luftpulsierungen 5 in den Innenraum des Hauptgehäuses 1 eingeleitet und verursachen dort die gewünschten Luftverwirbelungen. Dies ist in Figuren 1 symbolisch durch Pfeile dargestellt.

Bei einer anderen, nicht dargestellten Ausführung kann auch der Innenraum der Aktuatorkammer 34 des Schwingmembranlüfters 3 entweder alternativ oder zusätzlich zur Düsenkammer 33 über deren Luftführungskanäle 341 und weitere Durchführungsöffnungen 12 in den Seitenwänden 11 mit dem Innenraum des Hauptgehäuses 1 dicht gekoppelt sein. Die Ausführung mit doppeltem Anschluss sowohl von Düsen- 33 als auch Aktuatorkammer 34 bietet den besonderen Vorteil, dass die Leistung des Schwingmembranlüfters 3 besonders gut ausgenutzt wird und somit mit einem hohen Wirkungsgrad Verwirbelungen im Inneren des Hauptgehäuses hervorgerufen werden können. Zudem können durch die Bildung eines geschlossenen Luftvolumens aus den Innenräumen von Hauptgehäuse 1, Düsenkammer 33 und Aktuatorkammer 34 Druckschwankungen beim Betrieb des Schwingmembranlüfters in dem Luftvolumen weitgehend vermieden werden.

Bei dem in Figuren 1 dargestellten Beispiel sind das Hauptgehäuse 1 und das damit verbundene Teilgehäuse 31 des erfindungsgemäßen Gehäusesystems so zu einander platziert, dass die innen liegende Leiterplatte an deren Kanten über die Injektordüsen 331 angeblasen wird. Es stellt sich damit im Inneren des Hauptgehäuses einer parallel zur Oberseite der Leiterplatte verlaufende Luftströmung ein. Bei einer anderen, nicht dargestellten Ausführung können das Hauptgehäuse und das daran hermetisch dicht an gekoppelte Teilgehäuse auch so zu einander angeordneten sein, dass ein oder mehrere Punkte auf der Ober- bzw. Unterseite der Leiterplatte gezielt über die Injektordüsen 331 angeblasen werden. Eine solche Ausführung ist dann von Vorteil, wenn sich auf der Oberseite der Leiterplatte Bauelemente befinden, welche besonders viel Verlustwärme abgeben.

In Figur 2 ist ein weiteres Ausführungsbeispiel für ein gemäß der Erfindung aufgebautes Gehäusesystem dargestellt. Dabei ist das Teilgehäuse 31 des Schwingmembranlüfters 3 vollständig im Inneren des Hauptgehäuses 1 angeordnet. Im Beispiel der Figur 2 kann dieses z.B. auf der Oberseite der Leiterplatte 2 oder auf der Innenseite des oberhalb der Zeichenebene liegenden, in Figur 2 nicht dargestellten Deckels des Hauptgehäuses 1 angebracht sein. Gemäß einer weiteren Ausführungsform der Erfindung sind an das Teilgehäuse 31 zusätzlich Luftführungskanäle 41 angeschlossen. Diese können anstelle von Injektordüsen an die entsprechenden Luftauslassöffnungen der Düsenkammer bzw. an die Luftführungskanäle an den Luftauslassöffnungen der Aktuatorkammer angeschlossen sein.

Je nach Aufbau der Leiterplatte und deren Bestückung mit Bauelementen können diese Luftführungskanäle beliebig auf der Ober- und/oder Unterseite der Leiterplatte bzw. auch von der einen auf die andere Seite der Leiterplatte übergehend verlegt werden. Im Beispiel der Figur 2 sind die Enden der Luftführungskanäle 41 mit zusätzlichen Luftleitelementen 42, z.B. mit Schlitzdüsen 42, versehen. Hiermit können wie in Figur 2 dargestellt zirkulare Luftströmungen auf der Oberseite der Leiterplatte 2 hervorgerufen werden.

## Patentansprüche

1. Gehäusesystem mit einem Hauptgehäuse (1) zur Aufnahme von Verlustwärme abgebenden elektrischen und/oder elektronischen Bauelementen (2, 21), insbesondere Leiterplatten, und zumindest einem Schwingmembranlüfter (3) in einem Teilgehäuse (31), wobei die Innenräume von Haupt- (1) und Teilgehäuse (31) ein geschlossenes Luftvolumen bilden.

2. Gehäusesystem nach Anspruch 1, wobei an das Teilgehäuse (31) des Schwingmembranlüfters (3) Luftführungskanäle (41) angeschlossen und im Inneren des Hauptgehäuses (1) zur Erzielung zumindest einer Luftströmung verlegt sind.

3. Gehäusesystem nach Anspruch 1 oder 2, wobei das Teilgehäuse (31) des Schwingmembranlüfters (3) vollständig im Inneren des Hauptgehäuses (1) angeordnet ist.

4. Gehäusesystem nach Anspruch 1 oder 2, wobei das Teilgehäuse (31) des Schwingmembranlüfters (3) außerhalb des Hauptgehäuses (1) angeordnet und dessen Innenraum an den Innenraum des Hauptgehäuses (1) über zumindest eine Durchführungsöffnung (12) hermetisch dicht ankoppelbar ist.

5. Gehäusesystem nach Anspruch 4, wobei die zumindest eine Durchführungsöffnung (12) im Hauptgehäuse (1) wieder verschließbar ist.

6. Gehäusesystem nach Anspruch 4 oder 5, wobei auf dessen Außenseite das Teilgehäuse (31) des Schwingmembranlüfters (3) direkt aufgesetzt und dessen Innenraum über mindestens eine Injektordüsen (331) dicht an die zumindest eine Durchführungsöffnung (12) ankoppelt ist.

7. Gehäusesystem nach einem der vorangegangenen Ansprüche, **dadurch gekennzeichnet, dass**
- das Teilgehäuse (31) des Schwingmembranlüfters (3) von einer Schwingmembran (32) in eine Düsen- und eine Aktuatorkammer (33,34) geteilt ist,
- die Schwingmembran (32) von einem Magnetsystem (35) in der Aktuatorkammer (34) zu Schwingungen angeregt und davon erzeugte Luftpulsierungen (5) zumindest über die Düsenkammer (33) abgegeben werden, und
- der Innenraum des Hauptgehäuses (1) und die Düsen- bzw. Aktuatorkammer (33,34) des Teilgehäuses (31) des Schwingmembranlüfters (3) ein geschlossenes Luftvolumen bilden.
